# EUROPEAN PATENT APPLICATION

(11) **EP 4 525 036 A1**
(43) Date of publication of application: **19.03.2025**
(21) Application number: 22944670.3
(22) Date of filing: 15.12.2022
(51) Int. Cl.: H01L 23/40, H05K 1/02

(54) **HEAT DISSIPATION STRUCTURE, VEHICLE-MOUNTED DEVICE AND TERMINAL DEVICE**

(30) Priority: 28.05.2022 CN 202210592066
(71) Applicant: Shenzhen Yinwang Intelligent Technologies Co., Ltd., Shenzhen, Guangdong 518129 (CN)
(72) Inventor: CUI, Peihua, Shenzhen, Guangdong 518129 (CN); CHEN, Wangjia, Shenzhen, Guangdong 518129 (CN); WAN, Junping, Shenzhen, Guangdong 518129 (CN); LI, Kaimin, Shenzhen, Guangdong 518129 (CN)
(74) Representative: Gill Jennings & Every LLP
(86) International application number: PCT/CN2022/139232
(87) International publication number: WO 2023/231369

(57) **Abstract**

Embodiments of this application provide a heat dissipation structure, a vehicle-mounted device, and a terminal device, which are used in the field of heat dissipation technologies. The heat dissipation structure includes: a heat sink, a circuit board, a fixed connection structure, and an elastic connection structure. A chip mounting region and a first position are provided on the circuit board. The first position is located outside the chip mounting region. The fixed connection structure is located in the first position, and fastens the circuit board to the heat sink. The elastic connection structure is configured to provide an elastic force toward the heat sink for the chip mounting region. In embodiments of this application, the elastic force provided by the elastic connection structure can greatly reduce a thermal resistance between the chip and a housing of the heat sink, so that heat dissipation efficiency is improved. In addition, the fixed connection structure can fasten the circuit board to the heat sink, to avoid overall sliding of the circuit board and improve stability. Therefore, this application can improve heat dissipation efficiency while ensuring stability of the heat dissipation structure, and is especially applicable to stable heat dissipation of a high-power-consumption chip.

## Description

This application claims priority to Chinese Patent Application No. 202210592066.9, filed with the China National Intellectual Property Administration on May 28, 2022 and entitled "HEAT DISSIPATION STRUCTURE, VEHICLE-MOUNTED DEVICE, AND TERMINAL DEVICE", which is incorporated herein by reference in its entirety.

### TECHNICAL FIELD

This application relates to the field of heat dissipation technologies, and in particular, to a heat dissipation structure, a vehicle-mounted device, and a terminal device.

### BACKGROUND

With continuous development of intelligent technologies, various electronic devices are used in a terminal device, for example, a vehicle. Especially, an autonomous driving vehicle relates to many intelligent devices/systems. Therefore, a heat dissipation problem of these electronic devices in a working process is highlighted.

A large tolerance is set between a conventional vehicle-mounted heat sink and a chip. Therefore, thick thermal interface materials (like a gel or a thermal pad) need to be filled between the chip and the heat sink. Because the thermal interface materials are thick and have a large thermal resistance, heat dissipation efficiency is low when power consumption of the chip is high. However, with intelligence of the electronic device, power consumption of the electronic device in the terminal device increases by dozens of times, and such a heat dissipation manner cannot meet a heat dissipation requirement.

### SUMMARY

Embodiments of this application provide a heat dissipation structure, a vehicle-mounted device, and a terminal device, to improve heat dissipation efficiency of a high-power-consumption component.

According to a first aspect, an embodiment of this application provides a heat dissipation structure, including a heat sink, a circuit board, at least one fixed connection structure, and at least one elastic connection structure. At least one chip mounting region and at least one first position are provided on the circuit board, and the at least one first position is located outside the chip mounting region. The at least one fixed connection structure is located in the at least one first position, and fastens the circuit board to the heat sink. The at least one elastic connection structure is configured to provide an elastic force toward the heat sink for the chip mounting region.

In one aspect, the elastic force provided by the elastic connection structure can greatly reduce a thermal resistance between a chip and a housing of the heat sink, so that heat dissipation efficiency is improved. For example, the elastic connection structure may enable the chip mounting region to generate elastic deformation, and the elastic deformation absorbs an assembly tolerance, so that a chip located in the chip mounting region is closely attached to the heat sink (herein, the attachment may be direct attachment or may be attachment by using a medium). In this way, the thermal resistance between the chip and the housing of the heat sink is greatly reduced.

In another aspect, the fixed connection structure can fasten the circuit board to the heat sink to prevent the circuit board from integrally sliding, so that stability is improved. In conclusion, in this embodiment of this application, a temperature of the chip can be effectively reduced while an overall structure is kept stable, an over-temperature risk of the chip can be reduced, and security can be improved.

In a possible solution, a heat dissipation apparatus provided in embodiments of this application can be configured to dissipate heat for a chip in an intelligent mobile terminal. With popularization of intelligent mobile terminals, more and more chips are used in fields such as intelligent driving vehicles, uncrewed aerial vehicles, and mobile robots. However, because a mobile intelligent terminal needs to travel in an external environment or be carried to travel in an external environment, the mobile intelligent terminal often encounters a scenario like vibration or bump. In these scenarios, if the chip is in unstable contact with the heat sink and the chip is in unstable contact with the circuit board, not only heat dissipation efficiency of the chip is affected, but also an electrical connection failure may be caused. This affects normal operation of the intelligent terminal and endangers personal safety. However, according to the heat dissipation structure provided in embodiments of this application, a circuit board in which the chip is located and the heat sink can be securely fastened, and longitudinal deformation is generated only within a safe range of the chip, so that the chip is attached to the heat sink. In other words, stable and high heat dissipation efficiency can be provided, stability of the entire structure is enhanced, and security of the intelligent mobile terminal is improved.

It should be noted that in embodiments of this application, there may be a plurality of fixed connection structures and/or elastic connection structures.

When a plurality of fixed connection structures are disposed, the plurality of fixed connection structures may provide uniform and reliable fixed connections for the circuit board, and overall service lives of the fixed connection structures may be improved.

When a plurality of elastic connection structures are disposed, the plurality of elastic connection structures can improve overall service lives of the elastic connection structures. In addition, the plurality of elastic connection structures can enable an elastic force to be evenly distributed around the chip mounting region, thereby improving flatness of the chip mounting region. This can improve reliability of a connection between the chip and the circuit board, and can further ensure consistency and balance of an elastic top-holding force applied between the chip and the heat sink.

In still another possible implementation of the first aspect, the at least one fixed connection structure is configured to implement positioning of the circuit board in a horizontal direction. In this way, a possibility that the circuit board slides in the horizontal direction is reduced, and structural stability is improved.

Optionally, the at least one fixed connection structure includes a fastening screw. The fastening screw has enough fastening strength, so that the circuit board and the heat sink can be securely fastened.

In a possible implementation of the first aspect, the at least one elastic connection structure includes a fastener and an elastic member. The circuit board is provided with a through hole, and the fastener passes through the through hole and is fastened to the heat sink. The elastic member is sleeved on the fastener, and is elastically connected to the fastener and a surface that is of the circuit board and that is away from the heat sink.

In the foregoing implementation, the fastener is fastened to the heat sink through the through hole of the circuit board, and the elastic member sleeved on the fastener can be fastened in the horizontal direction (or referred to as a direction parallel to the circuit board). Therefore, deformation of the elastic member is mostly in a vertical direction (or referred to as a direction perpendicular to the circuit board), so that a direction of the elastic force provided by the elastic member is stable. In other words, through fastening of the fastener, the elastic member can stably provide an elastic force toward the heat sink for the circuit board. According to the solution provided in the foregoing implementation, the chip located in the chip mounting region is further stably attached to the heat sink, so that heat dissipation efficiency is improved.

In still another possible implementation of the first aspect, the at least one elastic connection structure includes a spring screw, a resilient sheet, or the like. The spring screw or the resilient sheet has sufficient support strength, and can be elastically deformed to provide an elastic force, so that the chip is closely attached to the heat sink.

In still another possible implementation of the first aspect, the at least one elastic connection structure is an elastic body, and the elastic body is elastically connected between the circuit board and a support body.

In the foregoing implementation, an elastic force is provided by using the elastic body located between the circuit board and the support body. In this case, no additional modification needs to be made to the circuit board and the heat sink, so that design complexity of the circuit board and the heat sink is reduced, and design costs and manufacturing costs are reduced.

In still another possible implementation of the first aspect, the support body is located on a side that is of the circuit board and that is away from the heat sink. The elastic body is compressed between the circuit board and the support body, so that the elastic body provides a "push force" for the circuit board. Correspondingly, the circuit board is "pushed" to the heat sink, so that the chip located in the chip mounting region is stably attached to the heat sink. This improves heat dissipation efficiency.

Optionally, the elastic body may be fastened by using a groove provided on the support body. In this case, there is no need to provide a through hole on the circuit board, so that design complexity of a circuit on the circuit board is reduced.

In still another possible implementation of the first aspect, the support body is located on a side that is of the circuit board and that faces the heat sink. The elastic body is stretched between the circuit board and the support body, so that the elastic body provides a "pull force" for the circuit board. Correspondingly, the circuit board is "pulled" to the heat sink, so that the chip located in the chip mounting region is stably attached to the heat sink. This improves heat dissipation efficiency.

In still another possible implementation of the first aspect, the support body is a housing of the heat dissipation structure.

Optionally, the heat dissipation structure may be accommodated in the housing. Further, optionally, the housing of the heat sink includes an upper housing and a lower housing (or referred to as a bottom housing), and the support body may be specifically the lower housing of the heat sink structure.

In still another possible implementation of the first aspect, the circuit board of the heat dissipation structure is connected to a stress-sensitive component, a distance between the stress-sensitive component and a first fixed connection structure is less than a distance between the stress-sensitive component and any elastic connection structure, and the first fixed connection structure belongs to the at least one fixed connection structure.

In this embodiment of this application, the stress-sensitive component is disposed in a position close to the fixed connection structure. In this way, damage or connection failure, due to deformation of the circuit board under the elastic force provided by the elastic connection structure, of the stress-sensitive component connected to the circuit board can be avoided.

In still another possible implementation of the first aspect, the heat dissipation structure further includes a connector and a mainboard. One end of the connector is connected to the circuit board, and the other end of the connector is connected to the mainboard. The connector can enable the circuit board to be electrically connected to the mainboard.

This setting meets requirements of different customers for different types of chips, and is highly applicable. In addition, if a capability of a chip needs to be upgraded, only the chip and the circuit board need to be replaced. Therefore, an evolution capability is strong, and upgrade and replacement costs are low. In addition, the foregoing implementation can further meet a requirement for adding or deleting a chip, so that flexibility of a component is improved.

In still another possible solution, the connector may be a flexible conductive member, and a signal interconnection between the connector and the mainboard is implemented by using the flexible conductive member. The flexible conductive member includes a flexible circuit board, a flexible connector, a cable, or the like. The flexible conductive member may implement a signal interconnection between the circuit board and the mainboard, and a flexible characteristic of the flexible conductive member can ensure reliability of an electrical connection when the circuit board floats up and down.

In a possible solution, the connector may be a BTB connector.

In still another possible implementation of the first aspect, a distance between the connector and a second fixed connection structure is less than a distance between the connector and any elastic connection structure, and the second fixed connection structure belongs to the at least one fixed connection structure.

It should be understood that the "first fixed connection structure" and the "second fixed connection structure" in this embodiment of this application are merely for ease of description, and there is no limitation that the two are definitely two different fixed connection structures. That is, the second fixed connection structure and the foregoing first fixed connection structure may be two different fixed connection structures, or may be a same fixed connection structure.

In still another possible implementation of the first aspect, there is one chip mounting region on the circuit board, the first position is located at an edge of the circuit board, and the chip mounting region is located in a central region of the circuit board.

In still another possible implementation of the first aspect, there are at least two chip mounting regions on the circuit board, and the first position is located between the at least two chip mounting regions.

In still another possible implementation of the first aspect, the chip mounting region is located on one side of the circuit board, and the first position is located on another side of the circuit board.

**In** still another possible implementation of the first aspect, the heat dissipation structure further includes a support, the support is fastened to the circuit board, an elastic force of the at least one elastic connection structure acts on the support, and the elastic force of the elastic connection structure is provided for the circuit board by using the support.

The support can improve rigidity of the chip mounting region. In this way, the elastic force of the elastic connection structure acts on the chip mounting region, so that an overall form of the chip mounting region can be ensured, flatness of the chip mounting region is not affected, reliability of a connection between the chip and the circuit board is ensured, and consistency and balance of an elastic top-holding force applied between the chip and the heat sink can be ensured.

**In** still another possible implementation of the first aspect, the heat dissipation structure is used in an autonomous driving controller, a cockpit domain controller, or a vehicle domain controller.

Because the structure of the vehicle is complex and the intelligence degree is increasingly high, power consumption of a chip in a controller of the vehicle is also increasing. According to this embodiment of this application, the heat dissipation structure can provide stable and efficient heat dissipation for the chip in the vehicle, thereby reducing an over-temperature risk of the chip and improving security.

**In** still another possible implementation of the first aspect, the heat sink is provided with a boss, and the boss is in a heat conduction to a heat emitting component (for example, a chip) in the chip mounting region. The boss is disposed, so that heat dissipation can be performed on the chip in a targeted manner, and heat dissipation efficiency is improved.

In still another possible implementation of the first aspect, a heat conduction medium is disposed between the heat sink and a heat emitting component (for example, a chip) in the chip mounting region.

Optionally, the heat conduction medium is silicone grease or a thermal pad (for example, a phase-change heat conduction film). A thermal resistance of the thermally conductive silicone grease and the phase-change heat conduction film is low, and an extremely small thickness can be implemented in a process. This helps reduce a temperature of the chip.

In still another possible implementation of the first aspect, a thickness of the thermal pad is less than or equal to 0.3 millimeter.

Under effect of the elastic fastening structure, the heat emitting component (for example, a chip) is closely attached to the heat sink, and the thickness of the heat conduction layer may be greatly reduced, so that a thermal resistance of the heat conduction layer can be greatly reduced and a temperature of the chip is effectively reduced.

In a possible implementation of the first aspect, the heat sink may dissipate heat in different forms such as air cooling or water cooling. In other words, the heat dissipation apparatus provided in this embodiment of this application is applicable to an air-cooling heat sink or a liquid-cooling heat sink.

In still another possible implementation of the first aspect, the heat sink includes a pipeline, where the pipeline is configured to fill a liquid, and the liquid includes water or a cooling material.

According to a second aspect, an embodiment of this application provides a vehicle-mounted device. The vehicle-mounted device includes the foregoing heat dissipation structure and at least one chip, and the at least one chip is disposed in at least one chip mounting region on a circuit board of the heat dissipation structure.

In one aspect, a fixed connection structure can fasten the circuit board to a heat sink to prevent the circuit board from integrally sliding, so that stability is improved. In another aspect, an elastic force provided by the elastic connection structure can enable the chip mounting region to generate elastic deformation, so that the chip is closely attached to the heat sink. This can greatly reduce a thermal resistance between the chip and a housing of the heat sink, and improve heat dissipation efficiency. In conclusion, in this embodiment of this application, a temperature of the chip can be effectively reduced while an overall structure is kept stable, and an over-temperature risk of the chip can be reduced.

It should be noted that a heat dissipation assembly is not only applicable to the foregoing vehicle-mounted device, but also applicable to one or more devices that have a heat dissipation requirement. For example, the heat dissipation assembly is used in a device like an intelligent terminal device, a network device, an equipment room device, an industrial device, a transport device, or a recreational entertainment device. The intelligent terminal device is, for example, a mobile phone, a tablet computer, a notebook computer, a smart band, a smart watch, or smart glasses. The network device is, for example, a metro router, a central router, or a base station. The equipment room device is, for example, a data center server or a data center switch. The industrial device is, for example, an industrial robot and a robot arm. The transport device is, for example, a vehicle, a ship, an aircraft, a rail transport (like a subway or a high-speed railway), or a logistics robot. The recreational entertainment device is, for example, a virtual reality (virtual reality, VR) device, a mixed reality (Mixed Reality, MR) device, a massage chair, or a 4D cinema cockpit. This is not strictly limited in embodiments of this application.

In a possible implementation of the second aspect, at least one elastic connection structure in the heat sink is configured to maintain a heat conduction connection between the at least one chip and the heat sink in the heat dissipation structure.

In a possible implementation of the second aspect, the vehicle-mounted device further includes a mainboard, there are a plurality of chips, and there are at least two heat dissipation structures.

The plurality of chips are mounted in chip mounting regions on circuit boards in the at least two heat dissipation structures, and the mainboard is electrically connected to the circuit boards in the plurality of heat dissipation structures.

A plurality of heat dissipation structures are disposed, so that a plurality of high-power-consumption chips separately implement conduction and heat dissipation with the heat sink. In addition, a plurality of circuit boards (or heat dissipation apparatuses) are disposed, so that not only can requirements of different customers for different types of chips be met, but also applicability is high. In addition, if a capability of a chip needs to be upgraded, only the chip and the circuit board need to be replaced. Therefore, an evolution capability is strong, and replacement costs are low. In addition, the foregoing implementation can further meet a requirement for adding or deleting a chip, so that flexibility of a component is improved.

In a possible implementation of the second aspect, the vehicle-mounted device is of an integrated plate-shaped structure.

In a possible implementation of the second aspect, the vehicle-mounted device is used in an electronic control unit (Electronic Control Unit, ECU) module using a high-power-consumption chip. The ECU module includes but is not limited to an autonomous driving controller, a cockpit domain controller (Cockpit Domain Controller, CDC), a vehicle domain controller (Vehicle Domain Controller, VDC), a vehicle integrated/integration unit (Vehicle Integrated/Integration Unit, VIU), or the like. The autonomous driving controller may be, for example, a mobile data center (Mobile Data Center, MDC).

According to a third aspect, this application further provides a terminal device. The terminal device includes the heat dissipation structure or the vehicle-mounted device described above.

In a possible implementation of the third aspect, the terminal device may be a transportation tool like a vehicle, an uncrewed aerial vehicle, a robot, a handheld terminal, or a wearable device.

### BRIEF DESCRIPTION OF DRAWINGS

FIG. 1 is a schematic diagram of a partial structure of a heat dissipation structure according to an embodiment of this application;
FIG. 2 is a schematic diagram of deformation of a circuit board according to an embodiment of this application;
FIG. 3 is a schematic diagram of a use scenario of a heat dissipation structure according to an embodiment of this application;
FIG. 4 is a schematic diagram of a chip mounting region and a first position according to an embodiment of this application;
FIG. 5A is a schematic diagram of another chip mounting region and a first position according to an embodiment of this application;
FIG. 5B is a schematic diagram of a partial structure of another heat dissipation structure according to an embodiment of this application;
FIG. 6A is a schematic diagram of another chip mounting region and a first position according to an embodiment of this application;
FIG. 6B is a schematic diagram of a partial structure of another heat dissipation structure according to an embodiment of this application;
FIG. 7 is a schematic diagram of a partial structure of another heat dissipation structure according to an embodiment of this application;
FIG. 8 is a schematic diagram of a partial structure of another heat dissipation structure according to an embodiment of this application;
FIG. 9 is a schematic diagram of a partial structure of another heat dissipation structure according to an embodiment of this application;
FIG. 10 is a schematic diagram of a partial structure of another heat dissipation structure according to an embodiment of this application;
FIG. 11 is a schematic diagram of a partial structure of another heat dissipation structure according to an embodiment of this application;
FIG. 12 is a schematic diagram of a partial structure of another heat dissipation structure according to an embodiment of this application;
FIG. 13A is a schematic diagram of a partial structure of a vehicle-mounted device according to an embodiment of this application;
FIG. 13B is a schematic diagram of a partial structure of another vehicle-mounted device according to an embodiment of this application;
FIG. 14 is a schematic diagram of a partial structure of another vehicle-mounted device according to an embodiment of this application;
FIG. 15A is a schematic diagram of a partial structure of another vehicle-mounted device according to an embodiment of this application;
FIG. 15B is a schematic diagram of a partial structure of another vehicle-mounted device according to an embodiment of this application; and
FIG. 16 is a schematic diagram of a partial structure of another vehicle-mounted device according to an embodiment of this application.

### Reference numerals:

101: heat sink; 1011: heat dissipation boss; 1012: fixed boss; 102: circuit board; 1021 (and 1021x): chip mounting region; 1022x: first position; 103: elastic connection structure, 1031: fastener; 1032: elastic member; 1033: elastic body; 104: fixed connection structure; 105: chip; 106: support body; 106a: housing; 106b: fixed boss on the housing; 107: mainboard; 108: connector; 109: support; 110: bottom housing; and 111: mainboard fastening member.

### DESCRIPTION OF EMBODIMENTS

With development of computer technologies, functions of electronic devices become more and more intelligent and diversified. The diversified and intelligent functions are implemented by computing modules with high computing power (the following uses a chip as an example for description). Power consumption of the chip increases as the computing power of the chip increases. A high-power-consumption chip generates a large amount of heat when working, and forms a hot zone. The hot zone has a high temperature, and needs to be heat-dissipated in a timely manner.

Currently, when a chip dissipates heat, a large tolerance exists between a heat sink and the chip. Therefore, thick thermal interface materials (like a gel or a thermal pad) need to be filled between the chip and the heat sink to implement heat dissipation.

It should be noted that a thermal resistance calculation formula is as follows: Thermal resistance=Filling thickness/(Thermal conductivity coefficient*Chip coating area)

A temperature difference calculation formula is as follows: Temperature difference=Chip power consumption*Thermal resistance Formula 2

For example, if a heat conduction medium with a thickness of 0.001 m (meter) is filled between the chip and the heat sink, for example, when a thermal conductivity coefficient of the heat conduction medium is 8 W/mk (watts per meter kelvin) and an effective heat transfer area of the chip is 0.024 m*0.024 m, the thermal resistance of the thermal gel is 0.217°C/W. For example, if power consumption of the chip is 66 W (watts), a temperature difference generated on a surface of the heat conduction medium is 14°C. The foregoing is merely an example in which the thickness of the heat conduction medium is 1 mm (millimeter). Actually, the heat conduction medium coated between the heat sink and the chip is usually thicker.

Because the thermal interface materials are thick and have a large thermal resistance, heat dissipation performance is likely to decrease sharply when power consumption of the chip increases, and there is an over-temperature trend of the chip. An over-temperature not only damages the chip, but also poses a security risk. This threatens users' lives and property.

In view of this, embodiments of this application provide a heat dissipation structure, a vehicle-mounted device, and a vehicle, to improve heat dissipation efficiency of a high-power-consumption component. In this embodiment of this application, a chip mounting region and a first position are provided on a circuit board. A heat sink is fastened to the circuit board at the first position by using a fixed connection structure, to avoid sliding of the circuit board. An elastic connection structure in the heat dissipation structure provides an elastic force toward the heat sink for the chip mounting region in the circuit board, so that a thermal resistance between the chip and the heat sink is reduced, and heat dissipation efficiency is improved.

The following specifically describes the heat dissipation structure and the vehicle-mounted device provided in embodiments of this application with reference to the accompanying drawings and specific embodiments. It should be noted that in embodiments of this application, heat dissipation of the chip by using the heat dissipation structure is used as an example for description. In a specific implementation process, the chip may be replaced with various heat emitting components. Similarly, the heat emitting component mounted in the chip mounting region not only includes a chip, but also may include another heat emitting component.

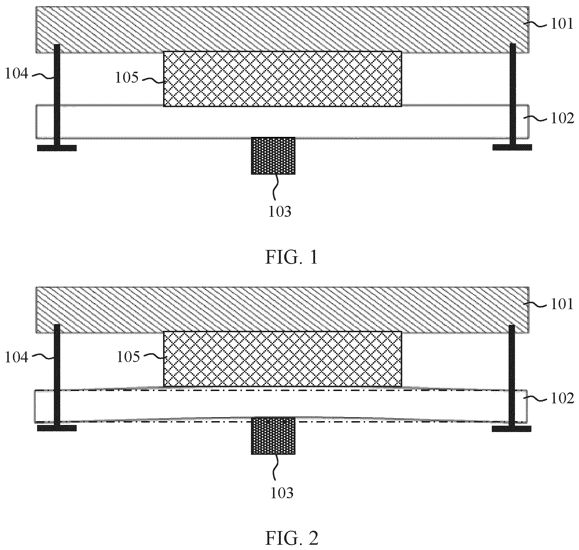

FIG. 1 is a schematic diagram of a partial structure of a heat dissipation structure according to an embodiment of this application. The heat dissipation structure may include a heat sink 101, a circuit board 102, a fixed connection structure 104, and an elastic connection structure 103.

The heat sink 101 is a structure having heat conduction and heat dissipation functions. A heat dissipation manner of the heat sink may be air-cooled heat dissipation, liquid-cooled heat dissipation, natural heat dissipation, or the like.

In a possible solution, the heat sink may be a water-cooled heat sink. A pipeline is disposed in the heat sink, and the pipeline may be filled with a liquid, so that heat is dissipated to the outside by flowing the liquid. The liquid in the pipeline may be water or another refrigerant.

In still another possible solution, the heat sink may be an air-cooled heat sink. For example, a plurality of heat dissipation fins are disposed on the heat sink, and the plurality of heat dissipation fins are arranged at intervals, so that a heat dissipation surface with a large area can be provided. After heat of a heat emitting component is transferred to the heat sink, the heat is dissipated to the outside through radiation and convection.

For targeted heat dissipation on a region in which a chip is located, a boss may be disposed on the heat sink 101. The boss is in a heat conduction connection to a heat emitting component (for example, a chip) in a chip mounting region. The boss is disposed, so that heat dissipation can be performed on the chip in a targeted manner, and heat dissipation efficiency is improved.

A chip mounting region and a first position are provided on the circuit board 102. A chip (for example, a chip 105 shown in FIG. 1) may be mounted in the chip mounting region. The first position is located outside the chip mounting region. Optionally, there may be one or more chip mounting regions and first positions.

Optionally, the circuit board 102 may be a printed circuit board (printed circuit board, PCB).

The elastic connection structure 103 is configured to provide an elastic force toward the heat sink 101 for the chip mounting region. The elastic connection structure provides the elastic force, so that the chip in the chip mounting region can be closely attached to the heat sink 101.

It should be understood that, the elastic connection structure 103 may absorb a tolerance, so that the chip 105 is closely attached to the heat sink 101, to implement efficient conduction and heat dissipation for the chip 105.

For example, the chip 105 has a thickness tolerance, the heat sink 101 has a height tolerance, and the circuit board 102 also has a thickness tolerance. Due to the existence of the tolerance, a distance between the chip 105 and the heat sink 101 is not a fixed value. FIG. 2 is a schematic diagram of possible deformation of a circuit board according to an embodiment of this application. The elastic connection structure 103 provides an upward elastic force for the chip mounting region, and absorbs a tolerance between the chip and the heat sink as much as possible, to implement close attachment between the chip 105 and the heat sink 101, and implement efficient conduction and heat dissipation for the chip 105.

In this embodiment of this application, the elastic connection structure 103 generates elastic deformation under an external force, and the generated elastic force is related to a deformation amount. When a distance between the chip 105 and the heat sink 101 is small, a deformation degree of the elastic connection structure 103 is small. When a distance between the chip 105 and the heat sink 101 is large, a deformation degree of the elastic connection structure 103 is large. In this way, the elastic connection structure 103 implements floating of the chip 105, so that the chip 105 can be always pressed on the heat sink 101, and it is ensured that the chip 105 and the heat sink 101 can maintain good heat conduction contact. It should be noted that, by properly setting a compression amount of the elastic connection structure 103, it can be ensured that pressure borne by the chip 105 falls within a safe range allowed by the chip 105, so that damage to the chip is avoided.

Under effect of the elastic connection structure 103, the chip 105 is closely attached to the heat sink 101, and a gap between the heat sink 101 and the chip 105 may be close to 0. However, in some scenarios, when the chip 105 is directly attached to the heat sink 101, a thermal resistance between the chip 105 and the heat sink 101 is large.

To improve heat dissipation efficiency, in a possible solution, a heat conduction medium (or a heat conduction layer) is filled between the chip 105 and the heat sink 101, and the heat conduction medium is used to reduce a thermal contact resistance between the chip 105 and the heat sink 101.

The heat conduction medium may include an interface material like thermally conductive silicone grease or a thermal pad (for example, a phase-change heat conduction film). The thermally conductive silicone grease and the phase-change heat conduction film have a low thermal conductivity coefficient, and can implement an extremely small thickness in a process, for example, less than or equal to 0.3 mm. A smaller thickness of the heat conduction medium indicates a smaller thermal resistance between the chip 105 and the heat sink 101, and higher heat dissipation efficiency.

In a possible implementation, the thickness of the heat conduction medium may be less than 0.2 mm, for example, the heat conduction medium is an ultra-thin thermal pad whose thickness is less than or equal to 0.2 mm. For example, when the thermally conductive silicone grease is used as the heat conduction medium, a thickness of the thermally conductive silicone grease reaches 0.1 mm.

Optionally, there are a plurality of possible cases of a position relationship between the elastic member in the elastic connection structure and the circuit board. For example, the elastic connection structure may be located on a side that is of the circuit board and that is away from the heat sink. When the elastic connection structure 103 is in a compressed state, an upward pressure (or referred to as a push force) is provided to the circuit board 102, so that a chip in the circuit board is closely attached to the heat sink 101. Alternatively, the elastic connection structure may be located on a side that is of the circuit board and that is close to the heat sink. When the elastic connection structure 103 is in an elongated state, an upward pull force is provided to the circuit board 102, so that a chip in the circuit board is closely attached to the heat sink 101.

The fixed connection structure 104 is located in the first position, and fastens the circuit board 102 to the heat sink 101. For example, the fixed connection structure 104 may be a fastening screw (for example, a threaded screw). To implement heat dissipation of the heat emitting component, the circuit board 102 and the heat sink 101 are disposed opposite to each other, and a side, on which the chip mounting region is provided, of the circuit board faces the heat sink.

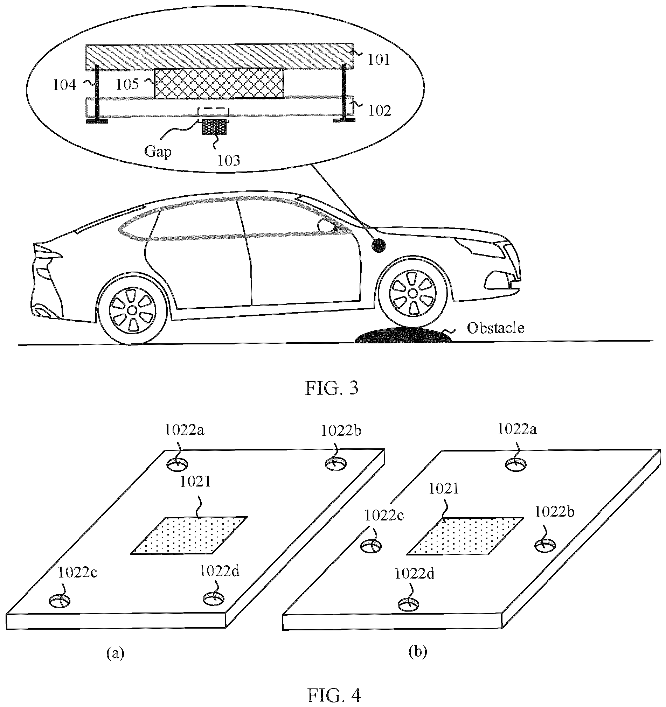

Because a direction of a force provided by the elastic connection structure 103 is perpendicular to the circuit board, the heat dissipation apparatus may slide in a horizontal direction under an external force. Horizontal sliding may cause an electrical connection failure, damage to a pin of the chip, and the like. FIG. 3 is a schematic diagram of a possible usage scenario of a heat dissipation structure according to an embodiment of this application. A heat dissipation apparatus is used in a vehicle to dissipate heat for a vehicle-mounted chip. The vehicle vibrates during moving. For example, when the vehicle passes through an obstacle, the vehicle may bump. The elastic connection structure 103 may generate large elastic deformation when the vehicle bumps. The elastic deformation needs to be recovered within a specific period of time. Therefore, there is a gap between the elastic connection structure 103 and the circuit board 102, so that the circuit board 102 has a risk of horizontal sliding. If the circuit board slides horizontally, an electrical connection between the circuit board and another device may fail. In addition, because a friction force exists between the chip 105 and the heat sink 101, a pin of the chip may be damaged through friction.

However, in this embodiment of this application, the fixed connection structure 104 may securely fasten the circuit board 102 and the heat sink 101, to implement horizontal positioning (the horizontal direction herein refers to a horizontal direction on a plane in which the circuit board 102 is located) of the circuit board 102. Even if the elastic connection structure 103 is affected by vibration and floats up and down, the fixed connection structure 104 may also fasten the circuit board 102, to prevent the circuit board 102 from integrally sliding, improve stability, and avoid a threat to personal and property safety of a user. In addition, if there is no fixed connection structure 104, when there is a gap between the elastic connection structure 103 and the circuit board 102 in a vibration process, a gap may also exist between the chip and the heat sink, and consequently, ideal heat dissipation effect cannot be implemented. In other words, when the elastic connection structure floats, the fixed connection structure 104 may control a spacing between the chip and the heat sink, and maintain a heat conduction connection between the chip and the heat sink, so that a heat dissipation apparatus can provide stable heat dissipation.

In conclusion, in embodiments of this application, a temperature of the chip can be effectively reduced while an overall structure is kept stable, an over-temperature risk of the chip can be reduced, and security can be improved.

For example, thermally conductive silicone grease with a thickness of 0.00001 m (namely, 0.1 mm) is used as a heat conduction medium. A thermal conductivity coefficient of the thermally conductive silicone grease is approximately 6 W/mk, and a coating area of the chip is still 0.024 m*0.024 m. The filling thickness, the thermal conductivity coefficient, and the coating area of the chip are substituted into the foregoing Formula 1, to obtain a thermal resistance of the thermally conductive silicone grease as 0.029°C/W.

For a chip whose power consumption is 66 W, the power consumption of the chip and the thermal resistance of the thermally conductive silicone grease are substituted into Formula 2, to obtain a temperature difference between an upper surface and a lower surface of the thermally conductive silicone grease as 1.9°C. Therefore, heat dissipation efficiency is high, and a temperature of the chip can be effectively reduced.

When a heat conduction medium with a thermal conductivity of 8 W/mk is used, a temperature difference generated by the heat conduction medium is approximately 1.4°C. Compared with a temperature difference of 14°C in the foregoing related technology, the temperature difference is reduced by approximately 12°C, so that heat dissipation effect is very obvious.

In this embodiment of this application, there may be one or more elastic connection structures 103. When a plurality of elastic connection structures are disposed, the plurality of elastic connection structures can improve overall service lives of the elastic connection structures. In addition, the plurality of elastic connection structures can enable an elastic force to be evenly distributed around the chip mounting region, thereby improving flatness of the chip mounting region. This can improve reliability of a connection between the chip and the circuit board, and can further ensure consistency and balance of an elastic top-holding force applied between the chip and the heat sink.

Similarly, there may be one or more fixed connection structures 104. When a plurality of fixed connection structures are disposed, the plurality of fixed connection structures may provide uniform and reliable fixed connections for the circuit board, and overall service lives of the fixed connection structures may be improved.

Based on the embodiment shown in FIG. 1, the following describes some possible designs of embodiments of this application. It should be noted that the following plurality of designs may be separately implemented, or may be combined for implementation. A case in which the plurality of designs are combined for implementation is not described again in embodiments of this application.

### [Design 1]

In the heat dissipation structure provided in this embodiment of this application, there may be one or more chip mounting regions and/or first positions on the circuit board.

Because the elastic connection structure 103 and the fixed connection structure 104 have different functions on the circuit board, in some possible implementations, there is a spacing between the chip mounting region and the first position. In other words, a spacing between the elastic connection structure 103 and the fixed connection structure is indirectly implemented. In this case, the chip mounting region in the circuit board is more prone to deformation, thereby improving heat dissipation effect and prolonging a service life of the elastic connection structure.

To facilitate understanding of a relationship between the chip mounting region and the first position, the following lists three possible cases.

Case 1: The chip mounting region is located in a central region of the circuit board, and the first position is located at an edge of the circuit board. FIG. 4 is a schematic diagram of a possible chip mounting region and first position according to an embodiment of this application. A chip mounting region 1021 is close to a geometric center on a plane of the circuit board 102. There are four first positions: a position 1022a, a position 1022b, a position 1022c, and a position 1022d. These positions are closer to an edge of the circuit board than the geometric center. It should be noted that there may be a plurality of possible cases of disposing close to the edge. This is not strictly limited in this application. For example, a plurality of first positions shown in (a) of FIG. 4 are provided at a plurality of corners of the circuit board. For another example, a plurality of first positions shown in (b) of FIG. 4 are provided near midpoints of a plurality of edges of the circuit board. For another example, a design of the first position may be further related to a circuit and an electronic element on the circuit board (for example, the first position is close to an electronic element).

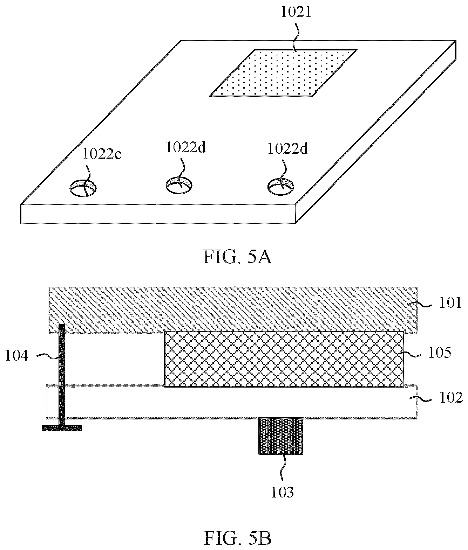

Case 2: The chip mounting region is located on one side of the circuit board, and the first position is located on another side of the circuit board. FIG. 5A is a schematic diagram of another possible chip mounting region and first position according to an embodiment of this application. FIG. 5B is a schematic diagram of a partial structure of another heat dissipation structure according to an embodiment of this application. For example, the first position includes four positions (which are a position 1022a, a position 1022b, and a position 1022c). The chip mounting region 1021 and the first position are respectively located on two sides of the circuit board, and there is a specific spacing between the chip mounting region 1021 and the first position. The fixed connection structure 104 is located in the first position, and fastens the circuit board 102 to the heat sink 101. The elastic connection structure 103 provides an elastic force toward the heat sink 101 for the chip mounting region.

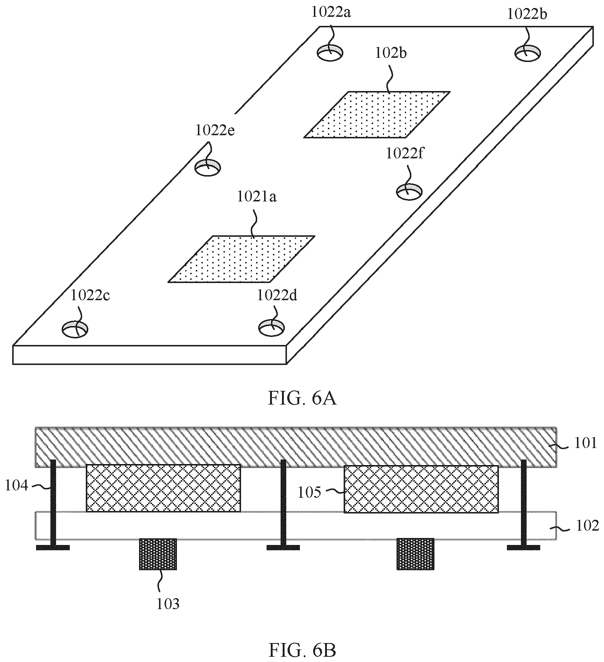

Case 3: There are a plurality of chip mounting regions, and the first position includes positions located between the plurality of chip mounting regions. FIG. 6A is a schematic diagram of still another possible chip mounting region and first position according to an embodiment of this application. FIG. 6B is a schematic diagram of a partial structure of still another heat dissipation structure according to an embodiment of this application. For example, the first position includes six positions (which are a position 1022a, a position 1022b, a position 1022c, a position 1022d, a position 1022e, and a position 1022f), and there are two chip mounting regions, which are chip mounting regions 1021a and 1021b. The elastic connection structure 103 is close to the chip mounting region, and provides an elastic force toward the heat sink 101 for each chip mounting region. The fixed connection structure 104 is disposed in the first position, and fastens the circuit board 102 to the heat sink 101.

The fixed connection structure 104 is disposed in the middle of the plurality of chip mounting regions, so that a floating amplitude of the circuit board 102 can be reduced, an excessive deformation amount at the chip mounting region can be avoided, and a service life of the circuit board is prolonged.

It should be noted that the foregoing plurality of cases may be combined with each other in a case in which the plurality of cases are not mutually exclusive. Details about the combined cases are not described herein.

### [Design 2]

The elastic connection structure 103 may include a spring screw, an elastic body, an elastic body, or the like. A position of the elastic connection structure is not strictly limited in this application. For example, the elastic connection structure 103 may be disposed around the chip mounting region of the circuit board. Herein, that the elastic connection structure 103 may be disposed around the chip mounting region of the circuit board means that the elastic connection structure 103 is located at an edge of the chip mounting region. For another example, a distance between the elastic connection structure 103 and a center of the chip mounting region is less than a distance between the fixed connection structure 104 and the center of the chip mounting region. For another example, the elastic connection structure 103 may alternatively be disposed in a region, corresponding to a range of the chip mounting region, on a side that is of the circuit board and that is away from the heat sink.

In some scenarios, the position of the elastic connection structure 103 is related to the structure of the elastic connection structure 103. For example, when the elastic connection structure 103 needs to pass through the circuit board, or is located on a side that is of the circuit board and that is close to the heat sink, the elastic connection structure is distributed around the chip mounting region, and forms an interval with the chip mounting region (to avoid damage to a circuit in the chip mounting region). When the elastic connection structure is located on a side that is of the circuit board and that is away from the heat sink, the elastic connection structure 103 may be disposed in a region, on the circuit board, corresponding to a range of the chip mounting region.

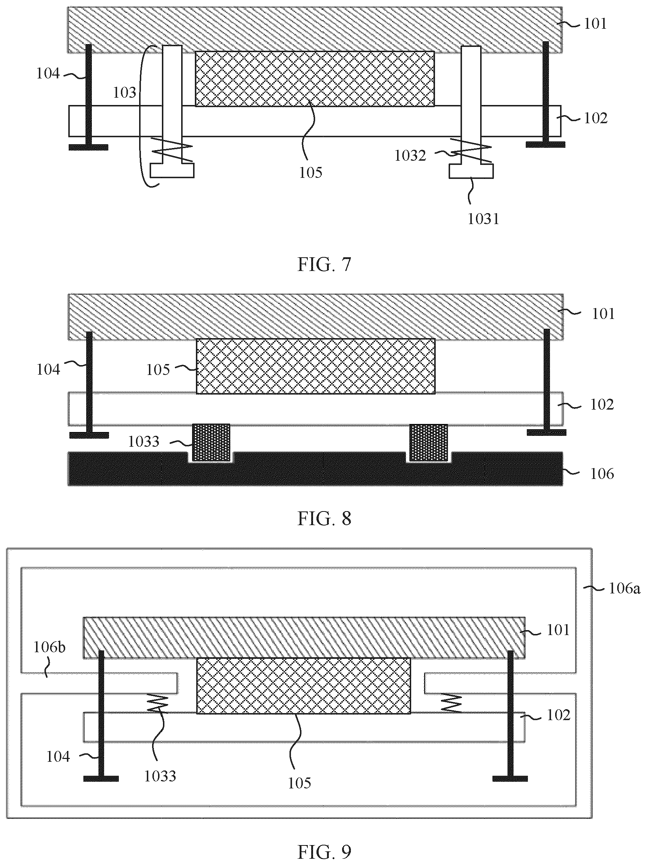

FIG. 7 is a schematic diagram of a partial structure of a possible heat dissipation structure according to an embodiment of this application. The elastic connection structure 103 includes a fastener 1031 and an elastic member 1032. The circuit board is provided with a through hole, and the fastener 1031 passes through the through hole and is fastened to the heat sink 101. The elastic member 1032 is sleeved on the fastener 1031, and elastically connects the fastener 1031 to the circuit board 102.

The fastener 1031 is fastened to the heat sink 101 through the through hole of the circuit board 102, and the elastic member 1032 sleeved on the fastener 1031 can be fastened in a horizontal direction (or referred to as a direction parallel to the circuit board). Therefore, deformation of the elastic member 1032 is mostly in a vertical direction (or referred to as a direction perpendicular to the circuit board 102), so that a direction of an elastic force provided by the elastic member 1032 is stable. In other words, through fastening of the fastener, the elastic member can stably provide an elastic force toward the heat sink for the circuit board. According to the solution provided in the foregoing implementation, the chip located in the chip mounting region is further stably attached to the heat sink, so that heat dissipation efficiency is improved.

To make the elastic member 1032 more stable, in a possible solution, an end that is of the elastic member 1032 and that is away from the circuit board 102 may be fastened on the fastener 1031. Certainly, the elastic member 1032 may alternatively not be fastened on the fastener. For example, the fastener 1031 has a protrusion at an end that is away from the circuit board 102, and the end that is of the elastic member 1032 and that is away from the circuit board 102 may press against the protrusion of the fastener 1031, to prevent the elastic member 1032 from sliding down from the fastener.

It should be understood that, because the chip mounting region of the circuit board floats up and down through the elastic member 1032, there is space between a hole wall of the through hole on the circuit board and the fastener. For example, when a cross section of the fastener and a cross section of the through hole are cylindrical, an outer diameter of a part of that is of the fastener and that is located in the through hole is less than an inner diameter of the through hole.

Optionally, in the embodiment shown in FIG. 7, the elastic connection structure 103 may be a spring screw. In this case, the fastener is a screw, and the elastic member is a spring. One end of the spring faces the circuit board, and the other end of the spring presses against the protrusion of the screw. The spring is in a compressed state, and provides an elastic force toward the heat sink 101 for the chip mounting region.

### [Design 3]

The elastic connection structure 103 may include an elastic body. The elastic body refers to a material that deforms when being subject to an external force, and can be restored to an original state and an original size after the external force is removed. For example, the elastic body is a spring or a polymer material that deform significantly under weak stress and can quickly recover to an original state and size after the stress is released. Optionally, there may be one or more elastic bodies.

FIG. 8 is a schematic diagram of a partial structure of still another possible heat dissipation structure according to an embodiment of this application. The elastic connection structure 103 includes an elastic body 1033, and a quantity of elastic bodies 1033 is 2 (this is only an example). The elastic body 1033 elastically connects the circuit board 102 to a support body 106. In other words, one end of the elastic body 1033 faces the circuit board 102, and the other end of the elastic body 1033 presses against the support body 106. A distance between the circuit board 102 and the support body 106 is less than a length of the elastic body in a natural state. In other words, the elastic body is in a compressed state, and can provide a "push force" for the circuit board 102. Correspondingly, a chip mounting region in the circuit board is "pushed" to the heat sink, so that a chip located in the chip mounting region is stably attached to the heat sink. This improves heat dissipation efficiency.

Optionally, the support body 106 may be a housing of the heat dissipation structure, or a partial housing. The housing encloses to form accommodating space, and the heat sink 101 and the circuit board 102 are located in the accommodating space. Further, optionally, the housing includes an upper housing and a lower housing (or referred to as a bottom housing), and the support body may be specifically the lower housing of the heat sink structure.

The foregoing example is described by using an example in which the support body is located on a side that is of the circuit board 102 and that is away from the heat sink 101. In a specific implementation process, the support body may be located on a side that is of the circuit board and that is close to the heat sink.

FIG. 9 is a schematic diagram of a partial structure of still another possible heat dissipation structure according to an embodiment of this application. A fixed boss 106b protrudes from a side wall of a housing 106a, and the fixed boss 106b is disposed on a side that is of the circuit board and that is close to the heat sink. One end of the elastic body 1033 is fastened to the fixed boss 106b, and the other end of the elastic body 1033 is connected to the circuit board 102. A length of the elastic body 1033 in a natural state is less than a distance between the circuit board 102 and the fixed boss 106b. In this way, the elastic body 1033 is in an elongated state, and provides a pull force toward the heat sink 101 for the chip mounting region of the circuit board 102, so that the chip 105 can be closely attached to the heat sink 101.

In some possible cases, a function of the support body 106 may be implemented by using the heat sink 101. In this way, parts of the heat dissipation structure are simplified, and manufacturing costs are reduced.

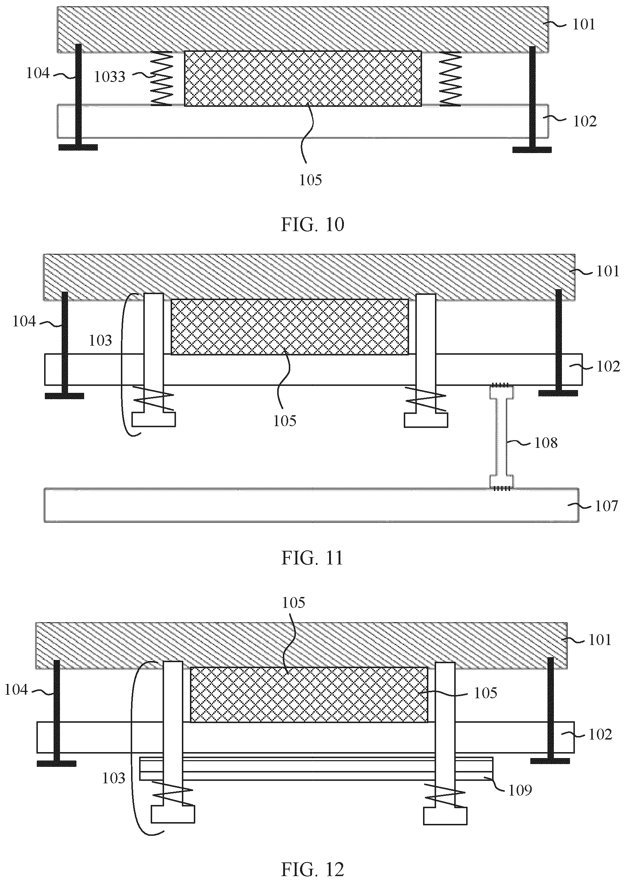

FIG. 10 is a schematic diagram of still another heat dissipation structure according to an embodiment of this application. One end of the elastic body 1033 is fastened to the heat sink 101, and the other end of the elastic body 1033 is connected to the circuit board 102. A length of the elastic body 1033 in a natural state is less than a distance between the circuit board 102 and the heat sink 101. In this way, the elastic body 1033 is in an elongated state, and provides a pull force toward the heat sink 101 for the chip mounting region of the circuit board 102, so that the chip 105 can be closely attached to the heat sink 101.

It should be noted that the elastic body may be fastened in a horizontal direction by using a fastening screw, a fastening hook, a fastening groove, welding, gluing, or the like.

For example, as shown in FIG. 8, the elastic body may be fastened by using a groove provided on the support body. In this implementation, there is no need to provide a through hole on the circuit board, so that design complexity of a circuit on the circuit board is reduced.

### [Design 4]

In some possible designs, the heat dissipation structure further includes a mainboard, and the mainboard is electrically connected to the circuit board 102. The mainboard (mainboard), also referred to as a main circuit board, a system board (system board), or a motherboard (motherboard), is a basic circuit board in a device (or a controller). Each of the circuit board 102 and the mainboard may be a printed circuit board (printed circuit board, PCB).

Generally, if the heat dissipation structure includes both the mainboard and the circuit board, an area of the mainboard is greater than an area of the circuit board 102. Certainly, in some scenarios, through a simplified design of the mainboard, an area of the mainboard may alternatively be less than an area of the circuit board 102. When the heat dissipation structure includes both the mainboard and the circuit board 102, the circuit board 102 may alternatively be referred to as a transfer circuit board or an extended circuit board.

An electrical connection between the mainboard and the circuit board 102 may be implemented by using a connector. The connector may include a board-to-board (board-to-board, BTB) connector, a flexible circuit board, a flexible connector, a cable, or the like. This setting meets requirements of different customers for different types of chips, and is highly applicable. In addition, if a capability of a chip needs to be upgraded, only the chip 105 and the circuit board 102 need to be replaced. Therefore, an evolution capability is strong, and upgrade and replacement costs are low. In addition, the foregoing implementation can further meet a requirement for adding or deleting a chip, so that flexibility of a component is improved.

FIG. 11 is a schematic diagram of a partial structure of still another possible heat dissipation structure according to an embodiment of this application. The mainboard 107 is connected to the circuit board 102 by using a connector 108, one end of the connector 108 is connected to the circuit board 102, and the other end of the connector 108 is connected to the mainboard 107. This setting can meet requirements of a user for different types of chips, and is highly applicable. When a chip is replaced, only the chip 105 and the circuit board 102 need to be replaced.

In addition, the embodiment shown in FIG. 11 can meet a requirement for adding or deleting a chip, so that flexibility of a component is improved. For example, a vehicle-mounted chip is used. If a chip needs to be installed on a vehicle of a specific type, only a plurality of circuit boards 102 need to be connected to the mainboard 107, so that convenient control on computing power is implemented.

In some scenarios, the connector may be a flexible conductive member, for example, the foregoing flexible circuit board, flexible connector, or cable. The flexible conductive member may implement a signal interconnection between the circuit board 102 and the mainboard 107, and a flexible characteristic of the flexible conductive member can ensure reliability of an electrical connection when the circuit board floats up and down.

Because the connector needs to implement an electrical connection between the circuit board and the mainboard, to improve signal connection stability, the connector may be disposed in a position close to the fixed connection structure.

In a possible implementation, a distance between the connector and the first fixed connection structure is less than a distance between the connector and any elastic connection structure, and the first fixed connection structure herein belongs to at least one fixed connection structure.

### [Design 5]

A plurality of electronic elements may be disposed on the circuit board, or the circuit board is connected to a plurality of electronic elements. Different electronic elements can bear different stresses. The stress includes but is not limited to an internal force in a unit cross-sectional area of an object caused by factors such as an external force, a non-uniform temperature field, and permanent deformation in the object. The stress may be used to describe structural strength of the electronic element.

For example, for an electronic element connected to a circuit board, if the circuit board 102 floats in a region, a large stress is generated in a floating process, and the stress affects the electronic element in the region. If the stress exceeds a stress that the electronic element can bear, electronic element failure or damage may be caused.

In this embodiment of this application, the stress-sensitive component is disposed in a position close to the fixed connection structure. For example, the stress-sensitive component includes a BTB connector, a crystal oscillator, a ceramic capacitor, a microphone component, or an electronic element packaged by using a ball grid array (ball grid array, BGA) packaging technology.

Because the fixed connection structure implements a fixed connection, in a vibration scenario, deformation of a circuit board around the fixed connection structure 104 is small. The stress-sensitive component is disposed in a position close to the fixed connection structure 104, to prevent the circuit board 102 from deforming due to an elastic force provided by the elastic connection structure 103, and prevent the stress-sensitive component connected to the circuit board 102 from being damaged or a connection failure.

The following lists several possible implementations in which the stress-sensitive component is disposed close to the fixed connection structure.

Implementation 1: A distance between the stress-sensitive component and the first fixed connection structure is less than a distance between the stress-sensitive component and any elastic fastening structure, and the first fixed connection structure is one of the at least one fixed connection structure. That is, the stress-sensitive component is closer to the fixed connection structure.

Implementation 2: A distance between the stress-sensitive component and the fixed connection structure is less than or less than or equal to N millimeters (mm), where N is a positive number. For example, N is 10 mm, 30 mm, 50 mm, or 100 mm. Optionally, N is related to rigidity of the circuit board and/or strength of the fixed connection structure.

Implementation 3: A distance between the stress-sensitive component and the elastic connection structure is greater than or greater than or equal to M millimeters (mm), where M is a positive number. For example, M is 5 mm, 10 mm, or 50 mm. In this way, it is equivalent to that a no-component region is provided around the elastic connection structure, so that the stress-sensitive component keeps a specific secure distance from the elastic connection structure 103. Optionally, N is related to rigidity of the circuit board and/or strength of the fixed connection structure.

It should be noted that the foregoing listed stress-sensitive component is merely an example. In a specific implementation process, determining of the stress-sensitive component is related to stress sensitivity of the electronic element or a tolerable deformation amount (the more sensitive the electronic device is to the stress, the smaller the tolerable deformation amount of the electronic device) of the electronic element. Alternatively, whether an electronic element belongs to the stress-sensitive component is determined by using a predefined and preconfigured determining rule. Alternatively, a stress measurement apparatus may be used to determine a bearable stress of an electronic element. When the bearable stress is less than or less than or equal to a threshold, the electronic element belongs to the stress-sensitive component.

In still another possible solution, a deformation range of each position on the circuit board is related to the elastic connection structure and the fixed connection structure on the circuit board. The closer to the position of the fixed connection structure, the lower an upper limit of the deformation amount. The closer to the position of the elastic connection structure, the higher the upper limit of the deformation amount.

Therefore, when the position of the electronic element is designed, a deformation range of each position on the circuit board and a tolerable deformation amount of the electronic element may be designed. When the tolerable deformation amount of the electronic element is less than a maximum deformation amount of the circuit board at a position A, the electronic element is a stress-sensitive component for the position A, and the electronic device cannot be disposed at the position A. When the tolerable deformation amount of the electronic element is greater than the maximum deformation amount of the circuit board at a position B, the electronic device can be disposed at the position B.

In still another possible solution, stresses at different positions on the circuit board can be determined through a simulation test or a simulation test. In this case, arrangement of the electronic element on the circuit board may be determined based on tolerable stress of the electronic element and stress distribution on the circuit board.

### [Design 6]

To improve balance of an elastic force, the heat dissipation apparatus may further include a support, and the support is configured to bear an elastic force provided by the elastic connection structure 103.

FIG. 12 is a schematic diagram of a partial structure of still another possible heat dissipation structure according to an embodiment of this application. The support 109 is fastened to the circuit board 102. The elastic force of the elastic connection structure 103 acts on the support 109, and is provided to the circuit board 102 through the support 109.

The support 109 can improve rigidity of the chip mounting region. The elastic force of the elastic connection structure 103 is applied to the chip mounting region by using the support 109, so that an overall form of the chip mounting region can be ensured, flatness of the chip mounting region is not affected, reliability of a connection between the chip 105 and the circuit board 102 is ensured, and consistency and balance of an elastic top-holding force applied between the chip 105 and the heat sink 101 can be ensured.

Optionally, the support may be rectangular, square, of a frame type, or the like.

For example, the support 109 may be of a frame type, and the frame-type support 109 is enclosed to form a plane. The elastic force of the elastic connection structure 103 acts on the support 109, and is uniformly provided to the circuit board 102. This prevents the force provided by the elastic connection structure from directly acting on the circuit board and damaging the circuit board. The support 109 is especially applicable to a mobile terminal or a wearable terminal. In a vibration scenario, the support 109 can effectively increase a stressed area of the circuit board, and ensure consistency and balance of an elastic top-holding force applied between the chip 105 and the heat sink 101. In addition, a hollow part of the frame-type support can be used to dispose a protrusion or an electronic element having a specific height, thereby increasing a use area of the circuit board.

Optionally, the support may be fastened to the circuit board. Optionally, the support may be fastened by using the elastic connection structure 103. Alternatively, optionally, the support may be fastened by using a fastening screw, a fastening connector, or the like.

In a possible implementation, when the elastic connection structure 103 includes the fastener 1031, as shown in the embodiment in FIG. 7, or the like, the fastener may alternatively be configured to fasten the support to the circuit board.

Certainly, if the elastic connection structure includes no fastener, another connector may alternatively be used to fasten the support to the circuit board.

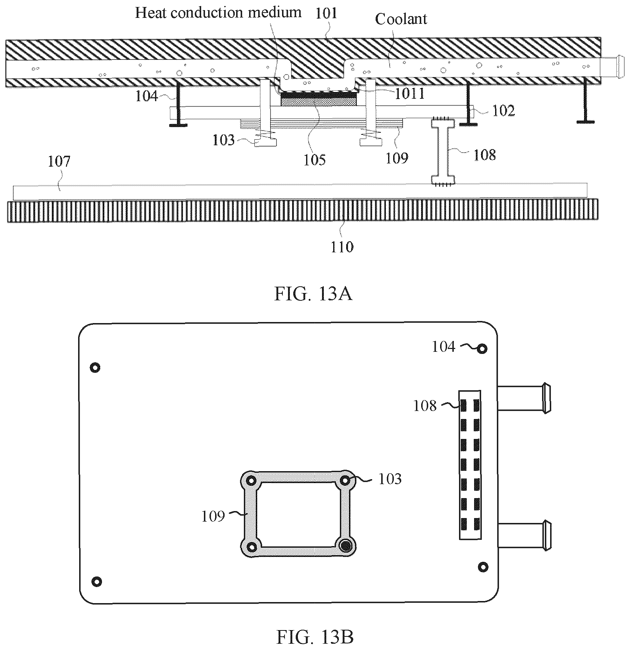

The embodiments shown in FIG. 1 to FIG. 12 include many possible implementation solutions. The following describes some of the implementation solutions by using examples with reference to FIG. 13A, FIG. 13B, FIG. 14, FIG. 15A, FIG. 15B, and FIG. 16. It should be noted that for related concepts, connection relationships, and function effects that are not explained in the following, refer to corresponding descriptions in the foregoing embodiments.

The heat dissipation structure in embodiments of this application may be used in a plurality of devices that have a heat dissipation requirement. For example, the heat dissipation structure is used in a device like an intelligent terminal device, a network device, an equipment room device, an industrial device, a transport device, or a recreational entertainment device. The intelligent terminal device is, for example, a mobile phone, a tablet computer, a notebook computer, a smart band, a smart watch, or smart glasses. The network device is, for example, a metro router, a central router, or a base station. The equipment room device is, for example, a data center server or a data center switch. The industrial device is, for example, an industrial robot and a robot arm. The transport device is, for example, a vehicle, a ship, an aircraft, a rail transport (like a subway or a high-speed railway), or a logistics robot. The recreational entertainment device is, for example, a virtual reality (virtual reality, VR) device, a mixed reality (Mixed Reality, MR) device, a massage chair, or a 4D cinema cockpit. This is not strictly limited in embodiments of this application.

The following uses a heat dissipation structure used in a vehicle as an example for description.

An embodiment of this application further provides a vehicle-mounted device, including a chip and the heat dissipation structure provided in the foregoing embodiments. The heat dissipation structure includes a heat sink 101, a circuit board 102, an elastic connection structure 103, and a fixed connection structure 104. The chip is disposed in a chip mounting region in the circuit board 102. The heat dissipation structure is configured to provide stable heat dissipation for the chip in the vehicle-mounted device.

Specifically, the elastic connection structure 103 of the heat sink may provide an elastic force toward the heat sink 101 for the chip mounting region, to maintain a heat conduction connection between the chip and the heat sink in the heat dissipation structure. The fixed connection structure 104 can fasten a circuit board on which a chip is located, thereby improving stability of the vehicle-mounted device and implementing heat dissipation of the chip.

The foregoing vehicle-mounted device may be, for example, an intelligent driving computing module, a cockpit domain controller (cockpit domain controller), a vehicle domain controller (Vehicle Domain Controller, VDC), a vehicle integrated unit (vehicle integrated unit), or a power module. The vehicle-mounted device may be mounted in a position like an engine compartment, a cockpit, a co-driver's glove box, or a head of an electric vehicle. These positions have a high ambient temperature and poor heat dissipation environment. With development of intelligent vehicles, power consumption of vehicle-mounted chips is continuously increasing, and a requirement for heat dissipation efficiency is also increasing. In addition, a bump is often generated in a driving process of the vehicle, and therefore, the vehicle-mounted device frequently generates vibration. In this case, a structure of the vehicle-mounted device needs to be stable. In short, the vehicle-mounted device needs a heat dissipation structure with a stable structure and high heat dissipation efficiency.

For example, the vehicle-mounted device is an intelligent driving module. The intelligent driving herein may be assisted driving, unmanned driving, or the like. For example, an advanced driving assistance system (Advanced Driving Assistance System, ADAS) is an assisted driving system. The ADAS can use various sensing apparatuses (including a visual system sensor, for example, a camera, a camera lens, and a radar system sensor) installed on the vehicle to sense an ambient environment, detect and recognize an object (including a pedestrian), and the like. The ADAS performs systematic calculation and analysis on a driving environment based on map data and the like, to plan a driving route and a driving operation. It can be learned that the ADAS needs to perform calculation and analysis on a large amount of data, and output a large amount of calculation data and/or a control signal. If an intelligent driving chip has an over-temperature risk, the life of a passenger is extremely likely to be in danger. Therefore, stable and efficient heat dissipation needs to be provided for the intelligent driving chip.

FIG. 13A and FIG. 13B are schematic diagrams of a partial structure of a vehicle-mounted device according to an embodiment of this application. As shown in FIG. 13A and FIG. 13B, the vehicle-mounted device includes a chip 105, a heat sink 101, a circuit board 102, an elastic connection structure 103, a fixed connection structure 104, a mainboard 107, a connector 108, a support 109, and a heat conduction medium.

The fixed connection structure 104 fastens the circuit board 102 to the heat sink 101, to prevent the circuit board 102 from sliding horizontally. Pressure provided by the elastic connection structure 103 acts on the support 109, so that the chip 105, the heat conduction medium, and a heat dissipation boss 1011 of the heat sink 101 are in close contact. An assembly tolerance between the chip 105 and the heat sink 101 is absorbed through deformation of a chip mounting region of the circuit board 102. During working, heat generated by the chip 105 is transferred to the heat sink 101 by using the heat conduction medium, and the heat is taken away by using a coolant flowing inside the heat sink 101.

The heat dissipation structure used in the vehicle-mounted device greatly reduces a thermal resistance between the chip and the heat sink, effectively improves heat dissipation efficiency, improves structural stability of the vehicle-mounted device by using a fastening screw, and implements stable heat dissipation for a high-power-consumption chip.

It should be understood that in the vehicle-mounted devices shown in FIG. 13A and FIG. 13B, a liquid cooling heat dissipation manner is merely an example. A heat sink that uses another heat dissipation manner is also used.

In a possible solution, the fixed connection structure 104 may be replaced with a fastening screw, the elastic connection structure 103 may be replaced with a spring screw, the connector 108 may be replaced with a BTB connector, and the support 109 is a frame-type support.

Optionally, a signal interconnection (or referred to as an electrical connection) is implemented between the mainboard and the circuit board by using the BTB connector. The BTB connector is disposed close to the fixed connection structure 104, to reduce a possibility of a BTB connector failure caused by displacement.

Optionally, a stress-sensitive component is disposed in a region near the fastening screw, to avoid damage to the stress-sensitive component, prolong a service life of the vehicle-mounted device, and meet a reliability requirement.

Optionally, the mainboard may be fastened to the heat sink, thereby improving stability of an overall structure.

Optionally, the vehicle-mounted device further includes a bottom housing 110. The bottom housing 110 is disposed on a side that is of the mainboard 107 and that is away from the circuit board 102. The bottom housing 110 is disposed to meet a dust-proof and water-proof design requirement, and can further fasten the mainboard, thereby improving stability of the mainboard and the entire vehicle-mounted device.

Optionally, the heat sink and the bottom housing of the vehicle-mounted structure are sealed and connected to form an integrated plate shape.

Optionally, there may be a plurality of chips, the plurality of chips are mounted in chip mounting regions on a plurality of circuit boards, and one or more chips may be mounted on each circuit board.

An assembly process of the vehicle-mounted device may be as follows: First, a heat conduction medium is installed on the heat dissipation boss 1011, and then the circuit board 102 is assembled on the heat sink 101. When a component on the circuit board 102 is installed, the fixed connection structure 104 is first installed around the circuit board 102. Second, the elastic connection structure 103 and the support 109 are integrally installed on the circuit board 102, and the elastic connection structure 103 is fastened, so that the support 109 can be fastened on the circuit board 102. The pressure provided by the elastic connection structure 103 enables the chip 105, a heat dissipation medium, and the heat dissipation boss 1011 to be in close contact. An assembly tolerance between the chip 105 and the heat sink 101 is absorbed through deformation of a central region of the circuit board 102. Then, the mainboard 107 is installed on the heat sink 101, and the mainboard 107 and the heat sink 101 are in a signal and electrical connection through the connector 108. Finally, the bottom housing 110 is installed.

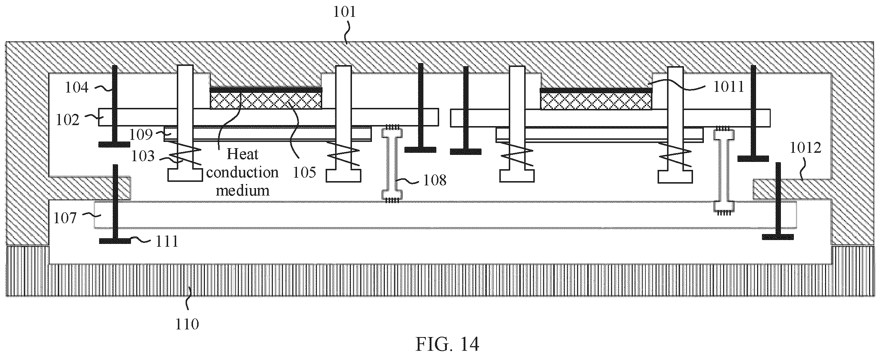

FIG. 14 is a schematic diagram of a partial structure of still another possible vehicle-mounted device according to an embodiment of this application. The vehicle-mounted device includes a heat sink 101, a circuit board 102, an elastic connection structure 103, a fixed connection structure 104, a chip 105, and a mainboard 107. In the vehicle-mounted device shown in FIG. 14, there are two heat dissipation structures. Circuit boards in the two heat dissipation structures are electrically connected to the mainboard. Each circuit board is connected to the mainboard 107 by using the connector 108.

In a possible solution, the vehicle-mounted device further includes a support 109, and the support 109 is disposed on some or all circuit boards, to provide a balanced elastic force for a chip mounting region in the circuit board. For related descriptions, refer to the foregoing descriptions. Details are not described herein again.

In a possible solution, a heat dissipation boss 1011 is disposed on the heat sink 101. The elastic connection structure 103 provides an elastic force for the chip mounting region, to implement close attachment between the chip 105, a heat conduction medium, and the heat dissipation boss 1011, thereby specifically dissipating heat for the chip and improving heat dissipation efficiency.

In a possible solution, a fixed boss 1012 is disposed on a side wall of the heat sink 101, and the mainboard 107 in the vehicle-mounted device is fastened to the fixed boss 1012. For example, the mainboard 107 is fastened to the fixed boss 1012 by using a fastening member 111.

In a possible solution, the heat dissipation apparatus further includes a bottom housing 110. It should be noted that the bottom housing 110 specifically refers to a housing (or a part of a housing) on a side that is of the circuit board and that is away from the heat sink.

Optionally, the bottom housing 110 may be attached to the heat sink 101 to meet a dust-proof and water-proof design requirement, and improve stability of the vehicle-mounted device. Optionally, the attachment herein may be attachment in a manner like gluing, engagement, or fastening by using a connector.

The foregoing describes a heat dissipation structure in which the circuit board is connected to the mainboard. The following describes a case in which the circuit board 102 is the mainboard.

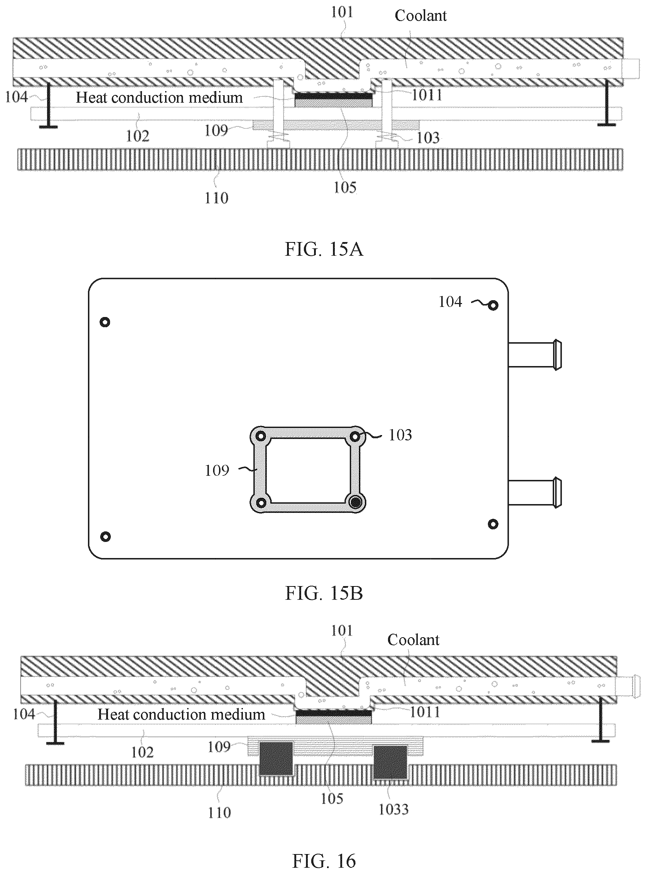

FIG. 15A and FIG. 15B are schematic diagrams of a partial structure of still another vehicle-mounted device according to an embodiment of this application. As shown in FIG. 15A and FIG. 15B, the vehicle-mounted device includes a chip 105, a heat sink 101, a circuit board 102, an elastic connection structure 103, a fixed connection structure 104, a support 109, and a heat conduction medium.

The fixed connection structure 104 fastens the circuit board 102 to the heat sink 101, to prevent the circuit board 102 from sliding horizontally. Pressure provided by a spring screw acts on the support, so that the chip 105, the heat conduction medium, and a heat dissipation boss 1011 of the heat sink 101 are in close contact. An assembly tolerance between the chip 105 and the heat sink 101 is absorbed through deformation of a chip mounting region of the circuit board 102. During working, heat generated by the chip 105 is transferred to the heat sink 101 by using the heat conduction medium, and the heat is taken away by using a coolant flowing inside the heat sink 101.

The heat dissipation structure used in the vehicle-mounted device greatly reduces a thermal resistance between the chip and the heat sink, effectively improves heat dissipation efficiency, improves structural stability of the vehicle-mounted device by using the fixed connection structure 104, and implements stable heat dissipation for a high-power-consumption chip.

It should be understood that in the vehicle-mounted devices shown in FIG. 15A and FIG. 15B, a liquid cooling heat dissipation manner is merely an example. A heat sink that uses another heat dissipation manner is also used.

Optionally, a stress-sensitive component is disposed in a region near the fixed connection structure 104, to avoid damage to the stress-sensitive component, prolong a service life of the vehicle-mounted device, and meet a reliability requirement.

Optionally, the vehicle-mounted device further includes a bottom housing 110. The bottom housing 110 is disposed on a side that is of the circuit board 102 and that is away from the heat sink 101. The bottom housing is disposed, so that dust-proof and water-proof design requirements can be met, and stability of the vehicle-mounted device is improved.

An assembly process of the vehicle-mounted device may be as follows: First, the heat conduction medium is installed on the heat dissipation boss 1011, and the circuit board 102 is configured on the heat sink 101 by using the fixed connection structure 104. Then, the support 109 and the elastic connection structure 103 are installed on the circuit board 102 and the heat sink 101, to fasten the elastic connection structure 103. The pressure provided by the elastic connection structure 103 enables the chip 105, a heat dissipation medium, and the heat dissipation boss 1011 to be in close contact. An assembly tolerance between the chip 105 and the heat sink 101 is absorbed through deformation of a central region of the circuit board 102. Finally, the bottom housing 110 is installed.

The foregoing describes an elastic connection structure including a spring screw. The following describes a vehicle-mounted device that uses an elastic body as an elastic connection structure.

FIG. 16 is a schematic diagram of a partial structure of still another vehicle-mounted device according to an embodiment of this application. As shown in FIG. 16, the vehicle-mounted device includes a chip 105, a heat sink 101, a circuit board 102, an elastic body 1033, a fixed connection structure 104, a support 109, a bottom housing 110, and a heat conduction medium.

The fixed connection structure 104 fastens the circuit board 102 to the heat sink 101, to prevent the circuit board 102 from sliding horizontally. The elastic body 1033 may be preinstalled on the bottom housing 110, or may be installed on the support 109. Pressure provided by the elastic body 1033 acts on the support 109, so that the chip 105, the heat conduction medium, and a heat dissipation boss 1011 are in close contact. An assembly tolerance between the chip 105 and the heat sink 101 is absorbed through deformation of a chip mounting region of the circuit board 102. During working, heat generated by the chip 105 is transferred to the heat sink 101 by using the heat conduction medium, and the heat is taken away by using a coolant flowing inside the heat sink 101.

The heat dissipation structure used in the vehicle-mounted device greatly reduces a thermal resistance between the chip and the heat sink, effectively improves heat dissipation efficiency, improves structural stability of the vehicle-mounted device by using a fastening screw, and implements stable heat dissipation for a high-power-consumption chip. In this implementation, the bottom housing not only participates in providing accommodating space, but also has a function of supporting the elastic body. The elastic connection structure disposed in this way does not need to be punched on the circuit board, thereby reducing complexity of a circuit design on the circuit board.

It should be understood that in the vehicle-mounted devices shown in FIG. 16, a liquid cooling heat dissipation manner is merely an example. A heat sink that uses another heat dissipation manner is also used.

Optionally, a stress-sensitive component is disposed in a region near the fixed connection structure 104, to avoid damage to the stress-sensitive component, prolong a service life of the vehicle-mounted device, and meet a reliability requirement.

Optionally, the vehicle-mounted device further includes a bottom housing 110. The bottom housing 110 is disposed on a side that is of the circuit board 102 and that is away from the heat sink 101. The bottom housing is disposed, so that dust-proof and water-proof design requirements can be met, and stability of the vehicle-mounted device is improved.

An embodiment of this application further provides a terminal. The terminal includes the heat dissipation structure or the vehicle-mounted device described above.

Optionally, the terminal may be a mobile terminal (for example, a vehicle), a handheld terminal, a wearable device, a transportation tool, a recreational entertainment device, or another intelligent device or transportation tool.

It should be noted that: The foregoing embodiments are merely used to describe the technical solutions of embodiments of this application, but not to limit the technical solutions. Although embodiments of this application are described in detail with reference to the foregoing embodiments, a person of ordinary skill in the art should understand that: The technical solutions described in the foregoing embodiments may still be modified, or some or all of the technical features thereof may be equivalently replaced. However, these modifications or replacements do not cause the essence of the corresponding technical solutions to depart from the scope of the technical solutions in the embodiments of this application.

In descriptions of this application, orientation or position relationships indicated by terms "center", "above", "below", "vertical", "horizontal", "inner", "outer", and the like are orientation or position relationships based on the accompanying drawings, and are only intended to facilitate and simplify the description of this application, but are not intended to indicate or imply that an apparatus or an element needs to have a specific orientation and be constructed and operated in a specific orientation, and therefore cannot be understood as a limitation on this application.

In descriptions of this application, unless otherwise clearly specified and limited, the term "connection" should be understood in a broad sense. For example, a "connection" may be a fixed connection, may be a detachable connection, may be an integral connection, may be a pressing connection or an integral connection. Contact of the connection may be a direct connection, or may be an indirect connection through an intermediate medium. For a person of ordinary skill in the art, a specific meaning of the foregoing terms in this application may be understood based on a specific situation.

In embodiments of this application, the term like "example" or "for example" is used to represent giving an example, an illustration, or a description. Any embodiment or design scheme described as an "example" or "for example" in this application should not be explained as being more preferred or having more advantages than another embodiment or design scheme. Exactly, use of the term "example", "for example", or the like is intended to present a related concept in a specific manner.

In embodiments of this application, "at least one" means one or more, and "a plurality of" means two or more. "At least one of the following items (pieces)" or a similar expression thereof refers to any combination of these items, including a single item (piece) or any combination of a plurality of items (pieces). For example, at least one of a, b, or c may indicate: a, b, c, (a and b), (a and c), (b and c), or (a, b, and c), where a, b, and c may be singular or plural. The term "and/or" describes an association relationship between associated objects, and indicates that three relationships may exist. For example, A and/or B may indicate the following three cases: Only A exists, both A and B exist, and only B exists, where A and B may be singular or plural. The character "/" generally indicates an "or" relationship between the associated objects.

In addition, unless otherwise stated, ordinal numbers such as "first" and "second" in the embodiments of this application are for differentiation between a plurality of objects, but are not intended to limit an order, a time sequence, priorities, or importance of the plurality of objects. For example, a first fastening structure and a second fastening structure are merely for ease of description, but do not indicate differences between the first fastening structure and the second fastening structure in terms of a material, an installation sequence, an importance degree, and the like. In some embodiments, the first fastening structure and the second fastening structure may alternatively be a same optical signal.

## Claims

1. A heat dissipation structure, comprising: a heat sink, a circuit board, at least one fixed connection structure, and at least one elastic connection structure, wherein
at least one chip mounting region and at least one first position are provided on the circuit board, and the at least one first position is located outside the chip mounting region;
the at least one fixed connection structure is located in the at least one first position, and fastens the circuit board to the heat sink; and
the at least one elastic connection structure is configured to provide an elastic force toward the heat sink for the chip mounting region.

2. The heat dissipation structure according to claim 1, wherein the at least one elastic connection structure comprises a fastener and an elastic member;
the circuit board is provided with a through hole, and the fastener passes through the through hole and is fastened to the heat sink; and
the elastic member is sleeved on the fastener, and is elastically connected to the fastener and a surface that is of the circuit board and that is away from the heat sink.

3. The heat dissipation structure according to claim 2, wherein the at least one fixed connection structure is configured to implement positioning of the circuit board in a horizontal direction.

4. The heat dissipation structure according to claim 1, wherein the at least one elastic connection structure is an elastic body, and the elastic body is elastically connected between the circuit board and a support body.

5. The heat dissipation structure according to claim 4, wherein the support body is located on a side that is of the circuit board and that is away from the heat sink.

6. The heat dissipation structure according to claim 4 or 5, wherein the support body is a housing of the heat dissipation structure.

7. The heat dissipation structure according to any one of claims 1 to 6, wherein the circuit board of the heat dissipation structure is connected to a stress-sensitive component, a distance between the stress-sensitive component and a first fixed connection structure is less than a distance between the stress-sensitive component and any elastic connection structure, and the first fixed connection structure belongs to the at least one fixed connection structure.

8. The heat dissipation structure according to any one of claims 1 to 7, wherein the heat dissipation structure further comprises a board-to-board BTB connector and a mainboard, one end of the BTB connector is connected to the circuit board, and the other end of the BTB connector is connected to the mainboard.

9. The heat dissipation structure according to claim 8, wherein a distance between the BTB connector and a second fixed connection structure is less than a distance between the BTB connector and any elastic connection structure, and the second fixed connection structure belongs to the at least one fixed connection structure.

10. The heat dissipation structure according to any one of claims 1 to 9, wherein there is one chip mounting region on the circuit board, the first position is located at an edge of the circuit board, and the chip mounting region is located in a central region of the circuit board; or
there are at least two chip mounting regions on the circuit board, and the first position is located between the at least two chip mounting regions; or
the chip mounting region is located on one side of the circuit board, and the first position is located on another side of the circuit board.

11. The heat dissipation structure according to any one of claims 1 to 10, wherein the heat dissipation structure further comprises a support, the support is fastened to the circuit board, an elastic force of the at least one elastic connection structure acts on the support, and the elastic force of the at least one elastic connection structure is provided for the circuit board by using the support.

12. The heat dissipation structure according to any one of claims 1 to 11, wherein the heat dissipation structure is used in an autonomous driving controller, a cockpit domain controller, or a vehicle domain controller.

13. A vehicle-mounted device, wherein the vehicle-mounted device comprises the heat dissipation structure according to any one of claims 1 to 12 and at least one chip, and the at least one chip is disposed in at least one chip mounting region on a circuit board of the heat dissipation structure.

14. The vehicle-mounted device according to claim 13, wherein at least one elastic connection structure in a heat sink is configured to maintain a heat conduction connection between the at least one chip and the heat sink in the heat dissipation structure.

15. The vehicle-mounted device according to claim 13 or 14, wherein the vehicle-mounted device further comprises a mainboard, there are a plurality of chips, and there are at least two heat dissipation structures, wherein
the plurality of chips are mounted in chip mounting regions on circuit boards in the at least two heat dissipation structures; and
the mainboard is electrically connected to the circuit boards in the plurality of heat dissipation structures.

16. The vehicle-mounted device according to any one of claims 13 to 15, wherein the vehicle-mounted device is of an integrated plate-shaped structure.

17. The vehicle-mounted device according to claim 13 or 14, wherein the vehicle-mounted device is used in an autonomous driving controller, a cockpit domain controller, or a vehicle domain controller.

18. A terminal device, comprising the heat dissipation structure according to any one of claims 1 to 12 or the vehicle-mounted device according to any one of claims 13 to 17.

19. The terminal device according to claim 18, wherein the terminal device is a vehicle, a robot, or an uncrewed aerial vehicle.
